# EUROPÄISCHE PATENTSCHRIFT

(11) **EP 3 661 893 B1**
(45) Veröffentlichungstag und Bekanntmachung des Hinweises auf die Patenterteilung: **22.01.2025**
(21) Anmeldenummer: 18717074.1
(22) Anmeldetag: 18.04.2018
(51) Int. Cl.: C04B 28/34, H01L 23/29, H01L 23/31, C04B 22/06, C04B 24/12, C04B 14/04, C04B 14/06, C04B 14/30, C04B 40/06, C04B 111/00

(54) **ZWEIKOMPONENTIGE ZUSAMMENSETZUNG ZUR HERSTELLUNG EINER WÄSSRIGEN UMHÜLLUNGSMASSE**
TWO-COMPONENT COMPOSITION FOR THE PREPARATION OF AN AQUEOUS COATING MASS
COMPOSITION À DEUX COMPOSANTS DESTINÉE À FABRIQUER UNE MATIÈRE DE REVÊTEMENT AQUEUSE

(30) Priorität: 31.07.2017 EP 17183916; 08.11.2017 EP 17200561
(43) Veröffentlichungstag der Anmeldung: 10.06.2020
(73) Patentinhaber: Heraeus Electronics GmbH & Co. KG, 63450 Hanau (DE)
(72) Erfinder: SCHEIBEL, Markus, 63450 Hanau (DE)
(74) Vertreter: Heraeus IP
(86) Internationale Anmeldenummer: PCT/EP2018/059820
(87) Internationale Veröffentlichungsnummer: WO 2019/025039

(56) Entgegenhaltungen:
- WO-A1-2015/193035
- DE-A1- 102013 102 301
- GB-A- 2 186 277
- US-A1- 2015 239 784

## Beschreibung

Die Erfindung betrifft eine zweikomponentige Zusammensetzung, die durch Vermischen mit Wasser in eine wässrige hydraulisch härtbare als Umhüllungsmasse verwendbare Zubereitung überführt werden kann. Die wässrige Umhüllungsmasse kann zur Herstellung einer hydraulisch gehärteten Umhüllung einer elektronischen Komponente verwendet werden.

Der hierin verwendete Begriff "elektronische Komponente" umfasst neben passiven elektronischen Bauteilen Halbleitermodule und unter letzteren insbesondere leistungselektronische Baugruppen.

Unter Halbleitermodulen werden hierin elektronische oder leistungselektronische Baugruppen umfassend mindestens ein Substrat (als Schaltungsträger), mindestens einen Halbleiterbaustein (Halbleiter) sowie gegebenenfalls mindestens ein passives elektronisches Bauteil verstanden. Der mindestens eine Halbleiterbaustein kann dabei selber schon teilweise oder vollständig vorumhüllt sein, beispielsweise mit einer Ummantelung auf Epoxidharzbasis.

Beispiele für Substrate sind IMS-Substrate (insulated metal-Substrate), DCB-Substrate (direct copper bonded-Substrate), AMB-Substrate (active metal brazing-Substrate), keramische Substrate, Metallkeramiksubstrate, PCBs (printed circuit boards) und Leadframes.

Beispiele für Halbleiterbausteine sind Dioden, LEDs (light emitting diodes), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxidesemiconductor field-effect transistors, Metall-Oxid-Halbleiter-Feldeffekttransistoren). Bei dem oder den Halbleiterbausteinen handelt es sich insbesondere um während des bestimmungsgemäßen Betriebs infolge Verlustleistung beträchtliche Wärme entwickelnde, d.h. ohne Umhüllung und unverkapselt selbstzerstörerische Temperaturen von beispielsweise 100 bis > 200°C erreichende Halbleiter.

Beispiele für passive elektronische Bauteile sind Sensoren, Bodenplatten, Kühlkörper, Widerstände, Kondensatoren, Transformatoren, Drosseln und Spulen.

Der hierin verwendete Begriff "hydraulisches Härten" umfasst ein Abbinden in Gegenwart von Wasser respektive nach Zusatz von Wasser.

GB 2 186 227 A offenbart ein zur Herstellung eines härtbaren Zements verwendbares Zweikomponentensystem umfassend als erste Komponente eine wässrige Lösung umfassend Phosphorsäure, Aluminiumdihydrogenphosphat und Alkali-, Erdalkali- oder Aluminiumsalz einer Säure mindestens so stark wie Phosphorsäure sowie als zweite Komponente ein Metalloxid-Härtungsmittel wie Magnesiumoxid.

US 2015/239784 A1 offenbart zum Verschließen von Tiefseebohrlöchern verwendbare härtbare Zemente, die hergestellt werden können durch Vermischen einer flüssigen, wässrigen Mischung umfassend Magnesiumoxid mit einer zweiten flüssigen, wässrigen Mischung umfassend Phosphorsäure oder Hydrogenphosphat.

Pulverförmige Zusammensetzungen und daraus herstellbare wässrige Umhüllungsmassen in Form von Phosphatzement sind beispielsweise in WO 2015/193035 A1 offenbart. Aus solchen wässrigen Phosphatzement-Umhüllungsmassen hergestellte Umhüllungen von elektronischen Komponenten dienen insbesondere der elektrischen Isolierung und der Wärmeabführung aus der elektronischen Komponente nach außen während des Betriebs.

Wie sich überraschend gezeigt hat und der folgenden Offenbarung entnommen werden kann, ist es insbesondere in Hinsicht auf eine Herstellung wässriger Phosphatzement-Umhüllungsmassen und deren Verwendung zur Herstellung von Umhüllungen, insbesondere von Umhüllungen elektronischer Komponenten, im industriellen Maßstab zweckmäßig, Zusammensetzungen, aus denen wässrige als Phosphatzement-Umhüllungsmassen verwendbare Zubereitungen hergestellt werden können, als Zweikomponentensystem bereitzustellen.

Die Erfindung betrifft eine Zusammensetzung wie in Anspruch 1 definiert.

Die aus den Bestandteilen (a) bis (c) respektive (a) bis (d) bestehende Zusammensetzung liegt somit in Form zweier Komponenten, d.h. voneinander verschiedener und separater Komponenten (separat zu lagernder bzw. separat gelagerter Komponenten) vor.

Mit anderen Worten, die Erfindung betrifft ein System aus zwei verschiedenen Komponenten umfassend keine weiteren als die folgenden Bestandteile:
(a) 1 bis 30 Gew.-% mindestens eines Hydrogenphosphats ausgewählt aus der Gruppe bestehend aus Mono- und Dihydrogenphosphaten von Natrium, Kalium, Magnesium, Calcium, Aluminium, Zink, Eisen, Kobalt und Kupfer,
(b) 1 bis 40 Gew.-% mindestens einer Verbindung ausgewählt aus der Gruppe bestehend aus Oxiden, Hydroxiden und Oxidhydraten von Magnesium, Calcium, Eisen, Zink und Kupfer,
(c) 40 bis 95 Gew.-% mindestens eines partikelförmigen Füllstoffs ausgewählt aus der Gruppe bestehend aus Glas; Mono-, Oligo- und Polyphosphaten von Magnesium, Calcium, Barium und Aluminium; Calciumsulfat; Bariumsulfat; einfachen und komplexen Silikaten umfassend Natrium, Kalium, Calcium, Aluminium, Magnesium, Eisen und/oder Zirkonium; einfachen und komplexen Aluminaten umfassend Natrium, Kalium, Calcium, Magnesium und/oder Zirkonium; einfachen und komplexen Titanaten umfassend Natrium, Kalium, Calcium, Aluminium, Magnesium, Barium und/oder Zirkonium; einfachen und komplexen Zirkonaten umfassend Natrium, Kalium, Calcium, Aluminium und/oder Magnesium; Zirkoniumdioxid; Titandioxid; Aluminiumoxid; Siliziumdioxid; Siliziumcarbid; Aluminiumnitrid; Bornitrid und Siliziumnitrid, und
(d) 0 bis 25 Gew.-% mindestens eines von den Bestandteilen (a) bis (c) verschiedenen Bestandteils,

wobei sich die Gew.-Anteile der Bestandteile (a) bis (c) respektive (a) bis (d) zu 100 Gew.-% addieren,
wobei es sich bei den komplexen Silikaten, komplexen Aluminaten, komplexen Titanaten und komplexen Zirkonaten um Silikate, Aluminate, Titanate und Zirkonate mit mehr als einer Art von Kationen handelt,
wobei Bestandteil (a) bis zu 10 Gew.-% freies Wasser, welches nicht als Kristallwasser im mindestens einen Hydrogenphosphat gebunden ist, bezogen auf den gesamten Bestandteil (a) umfassen kann,
wobei Bestandteil (d) bis zu 10 Gew.-% Wasser, bezogen auf den gesamten Bestandteil (d) umfassen kann,
wobei die Bestandteile (a) und (b) separat voneinander vorliegen.

Die Erfindung betrifft also eine zweikomponentige Zusammensetzung bestehend aus besagten Bestandteilen (a) bis (c) und, falls vorhanden, auch (d). Die Komponenten zusammen umfassen alle Bestandteile (a) bis (c) respektive (a) bis (d). Die Komponenten werden separat voneinander gelagert bis zu ihrer Verwendung zur Herstellung einer wässrigen hydraulisch härtbaren, alle Bestandteile (a) bis (c) respektive (a) bis (d) umfassenden Zubereitung. Die Herstellung einer solchen Zubereitung erfordert den Zusatz von bzw. das Vermischen mit Wasser.

Jeder der Bestandteile (a) bis (d) kann einen oder mehrere verschiedene Inhaltsstoffe, in der weiteren Folge auch als Subbestandteile bezeichnet, umfassen.

Um Verwechslungen vorzubeugen, hierin wird zwischen Bestandteilen (a) bis (d), Subbestandteilen dieser Bestandteile und Komponenten der erfindungsgemäßen zweikomponentigen Zusammensetzung unterschieden.

Bei dem 1 bis 30 Gew.-%, bevorzugt 2 bis 15 Gew.-% der erfindungsgemäßen zweikomponentigen Zusammensetzung ausmachenden Bestandteil (a) handelt es sich um mindestens eine Substanz ausgewählt aus der Gruppe bestehend aus Natriummonohydrogenphosphat, Kaliummonohydrogenphosphat, Magnesiummonohydrogenphosphat, Calciummonohydrogenphosphat, Aluminiummonohydrogenphosphat, Zinkmonohydrogenphosphat, Eisenmonohydrogenphosphat, Kobaltmonohydrogenphosphat, Kupfermonohydrogenphosphat, Natriumdihydrogenphosphat, Kaliumdihydrogenphosphat, Magnesiumdihydrogenphosphat, Calciumdihydrogenphosphat, Aluminiumdihydrogenphosphat, Zinkdihydrogenphosphat, Eisendihydrogenphosphat, Kobaltdihydrogenphosphat und Kupferdihydrogenphosphat. Mit anderen Worten, es handelt sich um mindestens ein Hydrogenphosphat ausgewählt aus der Gruppe bestehend aus Mono- und Dihydrogenphosphaten von Natrium, Kalium, Magnesium, Calcium, Aluminium, Zink, Eisen, Kobalt und Kupfer. Insbesondere handelt es sich um mindestens ein Hydrogenphosphat ausgewählt aus der Gruppe bestehend aus Mono- und Dihydrogenphosphaten von Magnesium, Kalium und Aluminium .

Bei Bestandteil (a) respektive dessen Subbestandteilen handelt es sich bevorzugt um Feststoffpartikel, beispielsweise mit Teilchengrößen im Bereich von bis zu 1 mm.

Bestandteil (a) kann bis zu 10 Gew.-% freies Wasser, bezogen auf den gesamten Bestandteil (a) aufweisen. Mit Blick auf Bestandteil (a) handelt es sich bei freiem Wasser um nicht als Kristallwasser im mindestens einen Hydrogenphosphat gebundenes Wasser. Bevorzugt umfasst Bestandteil (a) kein Wasser oder zumindest kein freies Wasser. Insbesondere umfasst Bestandteil (a) bevorzugt kein bewusst zugesetztes Wasser.

Bei dem 1 bis 40 Gew.-%, bevorzugt 2 bis 15 Gew.-% der erfindungsgemäßen zweikomponentigen Zusammensetzung ausmachenden Bestandteil (b) handelt es sich um mindestens eine Verbindung ausgewählt aus der Gruppe bestehend aus Oxiden, Hydroxiden und Oxidhydraten von Magnesium, Calcium, Eisen, Zink und Kupfer, insbesondere um mindestens eine Verbindung ausgewählt aus der Gruppe bestehend aus Magnesiumoxid, Eisenoxid und Calciumoxid. Magnesiumoxid ist besonders bevorzugt.

Bevorzugt handelt es sich bei dem Bestandteil (b) respektive dessen Subbestandteilen um Feststoffpartikel, beispielsweise mit Teilchengrößen im Bereich von bis zu 0,3 mm.

Bestandteil (b) umfasst kein freies Wasser und bevorzugt auch kein gebundenes Wasser. Bei erhöhter Temperatur aus Oxidhydraten austreibbares Wasser ist dabei nicht als gebundenes Wasser zu verstehen.

Bei dem 40 bis 95 Gew.-%, bevorzugt 65 bis 90 Gew.-% der erfindungsgemäßen zweikomponentigen Zusammensetzung ausmachenden Bestandteil (c) handelt es sich um mindestens einen partikelförmigen Füllstoff ausgewählt aus der Gruppe bestehend aus Glas; Mono-, Oligo- und Polyphosphaten von Magnesium, Calcium, Barium und Aluminium; Calciumsulfat; Bariumsulfat; einfachen und komplexen Silikaten umfassend Natrium, Kalium, Calcium, Aluminium, Magnesium, Eisen und/oder Zirkonium; einfachen und komplexen Aluminaten umfassend Natrium, Kalium, Calcium, Magnesium und/oder Zirkonium; einfachen und komplexen Titanaten umfassend Natrium, Kalium, Calcium, Aluminium, Magnesium, Barium und/oder Zirkonium; einfachen und komplexen Zirkonaten umfassend Natrium, Kalium, Calcium, Aluminium und/oder Magnesium; Zirkoniumdioxid; Titandioxid; Aluminiumoxid; Siliziumdioxid, insbesondere in Form von Kieselsäure und Quarz; Siliziumcarbid; Aluminiumnitrid; Bornitrid und Siliziumnitrid. Zirkoniumsilikat, Kieselsäure und Quarz sind bevorzugt.

Im vorstehenden Absatz werden Mono-, Oligo- und Polyphosphate erwähnt; zur Vermeidung von Missverständnissen, dabei handelt es sich im Gegensatz zu den Hydrogenphosphaten des Bestandteils (a) um von Wasserstoff freie Phosphate.

Im vorstehenden Absatz wird jeweils zwischen einfachen und komplexen Silikaten, Aluminaten, Titanaten und Zirkonaten unterschieden. Bei den komplexen Vertretern handelt es sich nicht etwa um Komplexverbindungen, vielmehr sind damit Silikate, Aluminate, Titanate und Zirkonate gemeint mit mehr als einer Art von Kationen, wie beispielsweise Natriumaluminiumsilikat, Calciumaluminiumsilikat, Bleizirkontitanat usw.

Die Teilchengrößen von Bestandteil (c) respektive dessen Subbestandteilen liegen beispielsweise im Bereich von 20 nm bis 0,3 mm oder sogar von 20 nm bis 1 mm.

Bestandteil (c) umfasst kein freies Wasser und bevorzugt auch kein gebundenes Wasser.

Bei dem 0 bis 25 Gew.-%, bevorzugt 0 bis 15 Gew.-% oder 2 bis 15 Gew.-% der erfindungsgemäßen zweikomponentigen Zusammensetzung ausmachenden Bestandteil (d) handelt es sich um mindestens einen von den Bestandteilen (a) bis (c) verschiedenen Bestandteil respektive Subbestandteile. Beispiele umfassen insbesondere Additive wie Fließverbesserer, Abbindeverzögerer (Topfzeitverlängerer), Entschäumer, Benetzungsmittel und Haftvermittler. Bestandteil (d) kann bis zu 10 Gew.-% Wasser, bezogen auf den gesamten Bestandteil (d), umfassen. Bevorzugt umfasst Bestandteil (d) kein Wasser, genauer gesagt, kein bewusst zugesetztes Wasser.

Bei dem Bestandteil (d) respektive seinen Subbestandteilen handelt es sich bevorzugt um Feststoffpartikel, beispielsweise mit Teilchengrößen im Bereich von bis zu 0,3 mm oder sogar bis zu 1 mm. Es ist möglich, wenn auch nicht bevorzugt, dass der Bestandteil (d) nicht fest, sondern beispielsweise flüssig ist oder nicht feste, beispielsweise flüssige Subbestandteile umfasst.

Folgende Tabelle illustriert einige Rezepturbeispiele bevorzugter Ausführungsformen erfindungsgemäßer zweikomponentiger Zusammensetzungen.

| Bestandteil | Ausführungsform 1 | Ausführungsform 2 | Ausführungsform 3 |
|---|---|---|---|
| (a), insbesondere Kalium- und/oder Aluminiumdihydrogen-phosphat | 3 - 9 Gew.-% | 6 - 12 Gew.-% | 12 - 23 Gew.-% |
| (b), insbesondere Magnesiumoxid | 3 - 8 Gew.-% | 5 - 14 Gew.-% | 8 - 19 Gew.-% |
| (c), insbesondere Zirkoniumsilikat | 70 - 90 Gew.-% | 55 - 80 Gew.-% | 45 - 65 Gew.-% |
| (d) | 0 - 13 Gew.-% | 9 - 19 Gew.-% | 13 - 25 Gew.-% |

Die erfindungsgemäße zweikomponentige Zusammensetzung besteht aus den Bestandteilen (a) bis (c) respektive (a) bis (d), d.h. die Gew.-%-Anteile der Bestandteile addieren sich zu 100 Gew.-% der erfindungsgemäßen zweikomponentigen Zusammensetzung. Falls kein Bestandteil (d) enthalten ist, addieren sich die Gew.-%-Anteile der Bestandteile (a) bis (c) zu 100 Gew.-% der erfindungsgemäßen zweikomponentigen Zusammensetzung.

In einer Ausführungsform liegen die Komponenten des erfindungsgemäßen Zweikomponentensystems in einer dem vorerwähnten Mengenverhältnis der Bestandteile (a) bis (c) respektive (a) bis (d) entsprechenden Bereitstellungsmenge vor, mit anderen Worten, fertig portioniert und somit unmittelbar ohne Abwiegen oder Abmessen direkt miteinander zur einkomponentigen Zusammensetzung bzw. zusätzlich mit Wasser zur wässrigen hydraulisch härtbaren Zubereitung vermischbar.

Die miteinander und mit Wasser zur wässrigen hydraulisch härtbaren Zubereitung zu vermischenden zwei Komponenten der erfindungsgemäßen zweikomponentigen Zusammensetzung werden bevorzugt in partikulärer Form bereitgestellt, beispielsweise in Pulverform. Dabei liegen mehr als einen, also zwei oder mehr verschiedene Bestandteile und/oder Subbestandteile umfassende partikuläre oder pulverförmige Komponenten des erfindungsgemäßen Zweikomponentensystems als innige Mischung vor, insbesondere als stochastisch homogene Mischung; solche partikulären Komponenten zeigen bevorzugt keine Klumpenbildung und sind rieselfähig.

Partikuläre Komponenten der erfindungsgemäßen zweikomponentigen Zusammensetzung können nach üblichen dem Fachmann bekannten Verfahren zur Herstellung rieselfähiger partikulärer Zusammensetzungen hergestellt werden. Beispielhaft seien Taumelmischen, Intensivmischen, Trockenvermahlung und Luftblending als Herstellungsverfahren erwähnt.

Die Komponenten der erfindungsgemäßen zweikomponentigen Zusammensetzung können, wie schon vorerwähnt, miteinander und mit Wasser zu einer wässrigen hydraulisch härtbaren Zubereitung vermischt werden.

Eine wässrige hydraulisch härtbare Zubereitung, insbesondere eine als wässrige Umhüllungsmasse verwendbare - also fertige - wässrige hydraulisch härtbare Zubereitung kann durch Vermischen der Komponenten der erfindungsgemäßen zweikomponentigen Zusammensetzung zu einer oder mehreren Vormischungen gefolgt von einem anschließenden Vermischen mit Wasser erhalten werden. So können beispielsweise zunächst alle Komponenten des erfindungsgemäßen Zweikomponentensystems ohne Wasserzusatz und anschließend mit Wasser zur wässrigen hydraulisch härtbaren Zubereitung vermischt werden.

Alternativ kann man zunächst mindestens eine der Komponenten der erfindungsgemäßen zweikomponentigen Zusammensetzung mit Wasser vermischen und so in mindestens ein wässriges Intermediat überführen. Als Resultat erhält man dabei ein vom ursprünglichen Zweikomponentensystem verschiedenes Zweikomponentensystem (vom ursprünglichen Zweikomponentensystem abgeleitetes Zweikomponentensystem; kurz auch als "abgeleitetes Zweikomponentensystem" bezeichnet) umfassend das mindestens eine wässrige Intermediat sowie die gegebenenfalls verbliebene nicht mit Wasser vermischte Komponente des ursprünglichen Zweikomponentensystems. Die Komponenten des so gebildeten abgeleiteten Zweikomponentensystems können demzufolge unmittelbar oder unter Zusatz von Wasser zu einer wässrigen hydraulisch härtbaren Zubereitung, insbesondere zu einer als wässrige Umhüllungsmasse verwendbaren - also fertigen - wässrigen hydraulisch härtbaren Zubereitung vermischt werden.

Ein abgeleitetes Zweikomponentensystem kann insbesondere folgende Ausführungsformen (i), (ii) oder (iii) annehmen:
(i) Abgeleitetes Zweikomponentensystem umfassend eine wässrige Komponente in Form eines wässrigen Intermediats A' umfassend den Bestandteil (a) ohne Anteile des Bestandteils (b) und eine weitere wässrige Komponente in Form eines wässrigen Intermediats B' umfassend den Bestandteil (b) ohne Anteile des Bestandteils (a). Ein solches wässriges Intermediat A' zeichnet sich durch eine praktisch unbegrenzte Lagerfähigkeit aus, während die Lagerfähigkeit eines solchen wässrigen Intermediats B' im Allgemeinen nicht mehr als 48 Stunden beträgt. Im Falle eines abgeleiteten Zweikomponentensystems vom Typ (i) können seine beiden wässrigen und dabei beispielsweise flüssigen oder pastösen Komponenten mittels einer geeigneten Zweikomponenten-Mischanlage, beispielsweise mittels eines statischen Mischers (insbesondere vom Kenics- oder Ross-ISG-Mischertyp) zur wässrigen hydraulisch härtbaren Zubereitung, insbesondere zu einer als wässrige Umhüllungsmasse verwendbaren - also fertigen - wässrigen hydraulisch härtbaren Zubereitung vermischt werden, insbesondere im Rahmen einer industriellen Serienproduktion, beispielsweise einer Serienfertigung entsprechender Umhüllungen bzw. umhüllter elektronischer Komponenten. Eine derartige Nutzung des abgeleiteten Zweikomponentensystems vom Typ (i) eignet sich insbesondere für die Durchführung beim Endanwender, d.h. beim Verwender der wässrigen hydraulisch härtbaren insbesondere als wässrige Umhüllungsmasse verwendbaren - also fertigen - wässrigen hydraulisch härtbaren Zubereitung.
(ii) Abgeleitetes Zweikomponentensystem umfassend eine nichtwässrige Komponente umfassend den Bestandteil (a) ohne Anteile des Bestandteils (b) und eine wässrige Komponente in Form eines wässrigen Intermediats umfassend den Bestandteil (b) ohne Anteile des Bestandteils (a). Ein solches wässriges Intermediat zeichnet sich wie vorerwähnt durch eine Lagerfähigkeit von im Allgemeinen nicht mehr als 48 Stunden aus. Ein Endanwender kann dieses abgeleitete Zweikomponentensystem vom Typ (ii) durch Überführung der nichtwässrigen den Bestandteil (a) ohne Anteile des Bestandteils (b) umfassenden Komponente durch Vermischen mit Wasser in ein abgeleitetes Zweikomponentensystem vom Typ (i) überführen.
(iii) Abgeleitetes Zweikomponentensystem umfassend eine wässrige Komponente umfassend den Bestandteil (a) ohne Anteile des Bestandteils (b) und eine nichtwässrige Komponente umfassend den Bestandteil (b) ohne Anteile des Bestandteils (a). Der Endanwender kann dieses abgeleitete Zweikomponentensystem vom Typ (iii) durch Überführung der nichtwässrigen den Bestandteil (b) ohne Anteile des Bestandteils (a) umfassenden Komponente durch Vermischen mit Wasser in ein abgeleitetes Zweikomponentensystem vom Typ (i) überführen.

Im Allgemeinen enthält eine wässrige hydraulisch härtbare Zubereitung der in Rede stehenden Art keinen Säureüberschuss; mit anderen Worten, im Allgemeinen kann der basische Bestandteil (b) nach Art und Menge so bemessen sein, dass die von Bestandteil (a) bereitgestellten Säureäquivalente sowie eventuelle weitere Säureäquivalente aus den Bestandteilen (c) und (d) zumindest vollständig neutralisiert, bevorzugt überneutralisiert werden können.

Beispielsweise können in Summe 100 Gewichtsteile der Komponenten, beispielsweise bevorzugt partikuläre Komponenten, der erfindungsgemäßen Zweikomponenten-Zusammensetzung mit 5 bis 30 Gewichtsteilen, bevorzugt 6 bis 15 Gewichtsteilen Wasser zur wässrigen hydraulisch härtbaren Zubereitung vermischt werden.

Wie gesagt, es ist möglich, zunächst alle Komponenten des erfindungsgemäßen Zweikomponentensystems ohne Wasserzusatz miteinander und danach mit Wasser zur wässrigen hydraulisch härtbaren Zubereitung zu vermischen. Allerdings ist es bevorzugt, mindestens eine der Komponenten zunächst mit Wasser zu mindestens einem wässrigen Intermediat zu vermischen und damit ein abgeleitetes Zweikomponentensystem zu schaffen. Danach kann ein Weitervermischen mit der weiteren Komponente und/oder dem weiteren wässrigen Intermediat erfolgen.

Bei der Herstellung der wässrigen hydraulisch härtbaren Zubereitung unter Verwendung der erfindungsgemäßen zweikomponentigen Zusammensetzung können deren einzelne Komponenten und das Wasser in beliebiger Reihenfolge, gegebenenfalls auch portionsweise, miteinander vermischt werden. Es ist dabei möglich, zunächst Zwischenprodukte in Form einer oder mehrerer vorerwähnter Vormischungen aus zwei Komponenten ohne Wasserzusatz und/oder in Form vorerwähnter wässriger Intermediate unter Wasserzusatz herzustellen. Bei wässrigen Intermediaten kann es sich gegebenenfalls um wässrige Lösungen handeln, beispielsweise wässrige Lösungen der Bestandteile (a) oder (d) oder eventueller Subbestandteile davon. Es kann zweckmäßig sein, wässrige Intermediate mit dem Bestandteil (b) und Anteilen mindestens eines sauren (in Gegenwart von Wasser H₃O⁺-Ionen bildenden) Bestandteils ausgewählt unter den Bestandteilen (a), (c) und (d) nicht länger als beispielsweise bis zu 2 bis 24 Stunden vor dem finalen Vermischen zur fertigen wässrigen hydraulisch härtbaren Zubereitung herzustellen. Ähnliches gilt für Bestandteil (b) oder Subbestandteile des Bestandteils (b) umfassende, von sauren Bestandteilen oder Subbestandteilen jedoch freie wässrige Intermediate; hier ist es zweckmäßig, solche wässrige Intermediate nicht länger als beispielsweise bis zu 48 Stunden vor dem finalen Vermischen zur wässrigen hydraulisch härtbaren Zubereitung herzustellen.

Beispiele für beim finalen Vermischen zur wässrigen hydraulisch härtbaren Zubereitung unter Verwendung der erfindungsgemäßen zweikomponentigen Zusammensetzung einsetzbare dynamische Mischverfahren sind Verrühren und Intensivmischen, beispielsweise Intensivmischen unter Verwendung von Planetenmischern.

In einer insbesondere in Hinsicht auf eine Verwendung der erfindungsgemäßen zweikomponentigen Zusammensetzung im industriellen Maßstab zweckmäßigen Ausführungsform umfasst die Zusammensetzung nur zwei Komponenten A und B. Komponente A umfasst dabei Bestandteil (a) und Komponente B Bestandteil (b). Die Bestandteile (a) und (b) können so während der Lagerung des erfindungsgemäßen Zweikomponentensystems separat voneinander gehalten werden. Die Bestandteile (c) und (d) können dabei in Komponente A und/oder B enthalten sein, wobei es bevorzugt ist, wenn zumindest Bestandteil (c) zu etwa gleichen Anteilen in beiden Komponenten A und B vorliegt. Beispielsweise können 30 bis 70 Gew.-%, bevorzugt 40 bis 60 Gew.-% des Bestandteils (c) in Komponente A und der restliche Anteil in Komponente B vorliegen. Es kann ferner bevorzugt sein, dass Komponente B keine Anteile von etwaigen sauren Bestandteilen (c) und (d) enthält. Solche etwaigen sauren Stoffe sind bevorzugt ausschließlich in Komponente A enthalten. Das Vermischen mit Wasser zur wässrigen hydraulisch härtbaren Zubereitung kann den vorerwähnten Prinzipien folgend durchgeführt werden. Bevorzugt ist es jedoch, beide Komponenten A und B jeweils mit Wasser in ein abgeleitetes Zweikomponentensystem vom vorerwähnten Typ (i) umfassend wässrige Intermediate A' und B' zu überführen und diese anschließend miteinander zur wässrigen hydraulisch härtbaren Zubereitung zu vermischen. Besondere Vorteile ergeben sich dabei im Hinblick auf eine Nutzung im industriellen Maßstab. Ein Komponente A bzw. den Bestandteil (a) ohne Anteile des Bestandteils (b) umfassendes wässriges Intermediat A' ist praktisch unbegrenzt lagerfähig. Ein von sauren Stoffen freies, Komponente B bzw. den Bestandteil (b) umfassendes wässriges Intermediat B' ist im Allgemeinen zumindest für einen Zeitraum von 48 Stunden lagerfähig. Bevorzugt können die wässrigen Intermediate A' und B' so formuliert werden, dass sie mit Blick auf ihr Mischungsverhältnis ähnliche, beispielsweise um nicht mehr als 20 % voneinander abweichende Volumina (entsprechend einem Volumenverhältnis von 1,2 : 1 bis 1 : 1,2) und/oder vergleichbare rheologische Eigenschaften, beispielsweise jeweils Viskositäten im Bereich von 0,5 bis 50 Pa s (Rotationsviskosimetrie, Platte-Platte-Messprinzip, Plattendurchmesser 25 mm, Messspalt 1 mm, Probentemperatur 20°C, Scherrate 36 min⁻¹, Viskositätswert bestimmt nach einer Messdauer von 2 Minuten) aufweisen. Eine Mischung beider wässriger Intermediate A' und B' stellt eine wässrige hydraulisch härtbare Zubereitung im vorerwähnten Sinne dar, bringt die Komponenten A und B und damit die Bestandteile (a) und (b) miteinander in Kontakt und hat eine Topfzeit (Verarbeitungszeitraum, Zeitdauer der Verarbeitungsfähigkeit) ausgedrückt als Zeitpunkt bis zur Verdoppelung der Anfangsviskosität (Viskosität nach 5 Minuten gerechnet ab erstem Inkontaktbringen der erfindungsgemäßen Zweikomponenten-Zusammensetzung und Wasser) von im Allgemeinen bis zu 120 Minuten. Es ist daher zweckmäßig, die beiden wässrigen Intermediate A' und B' separat und in größerer im Allgemeinen innerhalb eines Zeitraums von 48 Stunden zur Verarbeitung gelangender Gesamtmenge bereitzustellen und das Vermischen benötigter Portionen wässriger Intermediate A' und B' vor der Verwendung zum Umhüllen elektronischer Komponenten durchzuführen, beispielsweise unmittelbar oder nicht länger als 120 Minuten, bevorzugt nicht länger als 10 Minuten davor. Beispiele für in dem Zusammenhang nicht nur verwendbare, sondern besonders geeignete Zweikomponenten-Mischanlagen sind die vorerwähnten statischen Mischer, deren Auslassöffnung die wässrige hydraulisch härtbare Zubereitung in Form der miteinander im gewünschten Mischungsverhältnis hinreichend homogen miteinander vermischten wässrigen Intermediate A' und B' kontinuierlich oder portionsweise in benötigter Menge freigibt zwecks bestimmungsgemäßer Verwendung zur Umhüllung insbesondere elektronischer Komponenten. Beispielsweise kann das gewünschte Mischungsverhältnis der wässrigen Intermediate A' und B' dabei zweckmäßig dem schon vorerwähnten gewünschten Mengenverhältnis von erfindungsgemäßer Zweikomponenten-Zusammensetzung und Wasser entsprechen, beispielsweise dem vorerwähnten Mengenverhältnis von 100 Gewichtsteilen der erfindungsgemäßen Zweikomponenten-Zusammensetzung : 5 bis 30 Gewichtsteilen, bevorzugt 6 bis 15 Gewichtsteilen Wasser.

Wie schon gesagt, die wässrige, fließfähige und hydraulisch härtbare Zubereitung kann als wässrige Umhüllungsmasse für elektronische Komponenten verwendet werden. Der Kürze halber wird in der weiteren Folge der Begriff "wässrige Umhüllungsmasse" verwendet.

Die wässrige Umhüllungsmasse kann zur Herstellung einer hydraulisch gehärteten Umhüllung elektronischer Komponenten verwendet werden. Das im industriellen Maßstab im Rahmen einer industriellen Serienproduktion durchgeführte Verfahren zur Herstellung einer hydraulisch gehärteten Umhüllung einer elektronischen Komponente ist in Anspruch 6 definiert; es umfasst die Schritte:
(1) Bereitstellen einer zu umhüllenden elektronischen Komponente,
(2) Bereitstellen einer wässrigen Umhüllungsmasse in Form einer wässrigen hydraulisch härtbaren Zubereitung hergestellt durch Vermischen der Komponenten einer Zusammensetzung wie in einem der Ansprüche 1 bis 5 definiert miteinander und mit Wasser, wobei jede der beiden Komponenten des Zweikomponentensystems zunächst mit Wasser zu einem wässrigen Intermediat vermischt wird, bevor ein Weitervermischen erfolgt,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse.

Die Schritte (1) bis (4) bzw. das die Schritte (1) bis (4) umfassende Verfahren wird im industriellen Maßstab, d.h. im Rahmen einer industriellen Serienproduktion durchgeführt.

In Schritt (1) wird eine zu umhüllende elektronische Komponente bereitgestellt, nämlich ein passives elektronisches Bauteil oder ein Halbleitermodul, letzteres insbesondere in Form einer leistungselektronischen Baugruppe.

Bezüglich Schritt (2) wird auf das Vorerwähnte verwiesen, wobei jede der beiden Komponenten des Zweikomponentensystems zunächst mit Wasser zu einem wässrigen Intermediat vermischt wird, bevor ein Weitervermischen erfolgt. Der im industriellen Maßstab verwirklichte Schritt (2) erfolgt durch Vermischen wässriger Intermediate A' und B' eines abgeleiteten Zweikomponentensystems vom Typ (i) unter Verwendung eines statischen Mischers, insbesondere vom Kenics- oder Ross-ISG-Mischertyp. Dabei umfasst Schritt (2) folgende Teilschritte:
(2a) Bereitstellen einer erfindungsgemäßen zweikomponentigen Zusammensetzung wie in einem der Ansprüche 1 bis 5 definiert aus einer ersten Komponente A umfassend Bestandteil (a) und einer zweiten Komponente B umfassend Bestandteil (b),
(2b) separates Vermischen jeder der Komponenten A und B mit Wasser zu zwei separaten wässrigen Intermediaten A' und B', und
(2c) Vermischen der wässrigen Intermediate A' und B' mittels eines statischen Mischers zu einer wässrigen Umhüllungsmasse in Form einer wässrigen hydraulisch härtbaren Zubereitung. Dabei ist es bevorzugt, dass die beiden wässrigen Intermediate A' und B' um nicht mehr als 20 % voneinander abweichende Volumina und/oder jeweils eine Viskosität im Bereich von 0,5 bis 50 Pa s (Rotationsviskosimetrie, Platte-Platte-Messprinzip, Plattendurchmesser 25 mm, Messspalt 1 mm, Probentemperatur 20°C, Scherrate 36 min⁻¹, Viskositätswert bestimmt nach einer Messdauer von 2 Minuten) aufweisen.

Bevorzugt wird Schritt (3) unverzüglich, beispielsweise innerhalb von 120 Minuten, bevorzugt innerhalb von 10 Minuten nach Beendigung von Schritt (2) durchgeführt.

In Schritt (3) erfolgt das Umhüllen der in Schritt (1) bereitgestellten elektronischen Komponente mit der gemäß Schritt (2) bereitgestellten wässrigen Umhüllungsmasse. Bevorzugte Applikationsmethoden sind Vergießen, Tauchen und Spritzgießen. Das Vergießen kann mittels üblichen, dem Fachmann bekannten Methoden erfolgen, beispielsweise durch Schwerkraft-, druckunterstützten oder druckvermindertem Verguss. Dabei kann es zweckmäßig sein, die zu umhüllende elektronische Komponente mit Halbschalenformen zu umschließen und dann mit der gießfähigen Umhüllungsmasse zu füllen. Das Umhüllen kann als teilweises oder vollständiges Umhüllen erfolgen. Beispielsweise kann bei der Umhüllung eines Halbleitermoduls so gearbeitet werden, dass die Umhüllungsmasse mit dem Halbleiterbaustein verbundene elektrische Kontaktierungselemente wie beispielsweise Bonddrähte, Bändchen und/oder ein Substrat teilweise oder vollständig umhüllt. Teilweise Umhüllung bedeutet dabei, dass ein oder mehrere der Kontaktierungselemente unvollständig und/oder ein oder mehrere der Kontaktierungselemente nicht umhüllt sind, während vollständige Umhüllung bedeutet, dass alle Kontaktierungselemente vollständig umhüllt sind. Das Vergießen kann aber beispielsweise auch so erfolgen, dass die Umhüllungsmasse als dem Fachmann bekanntes "glob-top" ausgebildet wird.

Im auf Schritt (3) folgenden Schritt (4) wird die wässrige die elektronische Komponente umhüllende Umhüllungsmasse hydraulisch gehärtet. Genauer gesagt, findet der wesentliche Teil des hydraulischen Härtens einschließlich des Abbindens während Schritt (4) statt; selbstverständlich beginnt das hydraulische Härten schon ab dem Moment, in dem die Bestandteile (a) und (b) in Gegenwart von Wasser miteinander in Kontakt gekommen sind, d.h. schon im Zuge von Schritt (2). Während und nach dem eigentlichen Abbinden kann ein Trocknen im Sinne einer Entfernung von Wasser bzw. des Wassers erfolgen. Abbinden und Trocknen können während beispielsweise 30 bis 300 Minuten in einem Temperaturbereich von beispielsweise 20 bis 300 °C erfolgen.

Im Falle des Arbeitens mit Halbschalenformen in Schritt (3) kann die umhüllte elektronische Komponente nach der hydraulischen Härtung gemäß Schritt (4) und Öffnen der Halbschalen letzteren entnommen werden.

### Beispiele

### Allgemeine Durchführung:

Die in nachfolgender Tabelle beschriebenen pulverförmigen Feststoffzusammensetzungen wurden pro Komponente in je einem Becher mit Schraubdeckel entsprechend eingewogen. Nach Verschließen des Bechers wurde jede Komponente einzeln manuell mittels Schütteln homogenisiert und dann zu in einem weiteren Becher vorgelegten Wasser gegeben und innerhalb 5 Minuten durch intensives Rühren zu einem wässrigen Intermediat homogenisiert. Das Mischungsverhältnis betrug für jedes wässrige Intermediat 100 Gew.-Teile Feststoffzusammensetzung : 10 Gew.-Teile Wasser. Die so erhaltenen wässrigen Intermediate wurden in die Messzelle eines Rheometers gegeben und es wurde die jeweilige Anfangsviskosität entsprechend den Ausführungen in der vorhergehenden Beschreibung bestimmt. Anschließend wurden beide wässrigen Intermediate im angegebenen Massenverhältnis zusammengegeben und mittels intensivem Rühren zu einer wässrigen Umhüllungsmasse homogenisiert. Diese wurde in die Messzelle des Rheometers gegeben und es wurde die Topfzeit entsprechend den Ausführungen in der vorhergehenden Beschreibung bestimmt.

| | Beispiel 1 | | Beispiel 2 | |
|---|---|---|---|---|
| Bestandteil | Komponente A | Komponente B | Komponente A | Komponente B |
| (a) Kaliumdihydrogenphosphat | 3,84 | 0 | 3,84 | 0 |
| (b) Magnesiumoxid D₅₀ = 18 µm | 0 | 4,6 | 0 | 4,6 |
| (c) Zirkoniumsilikat D₅₀ = 10 µm | 19,4 | 17,92 | 21,3 | 16 |
| (d1) Harnstoff | 2,4 | 3,6 | 2,4 | 3,6 |
| (d2) L-Weinsäure | 0,36 | 2,04 | 0,36 | 2,04 |
| (d3) Trinatriumcitrattrihydrat | 0,36 | 2,04 | 0,36 | 2,04 |
| | | | | |
| Relativer Massenanteil des wässrigen Intermediats | 1 | 1,13 | 1 | 1 |
| Anfangsviskosität des wässrigen Intermediats [Pa·s] | 2 | 4 | 2 | 2,5 |
| Lagerfähigkeit der Komponente B | | 50 h | | 50 h |
| Topfzeit der Umhüllungsmasse | 50 min | | 50 min | |

| | | | | |
|---|---|---|---|---|
| D₅₀ = mittlerer Partikeldurchmesser | | | | |

## Patentansprüche

1. Zusammensetzung bestehend aus den Bestandteilen:
(a) 1 bis 30 Gew.-% mindestens eines Hydrogenphosphats ausgewählt aus der Gruppe bestehend aus Mono- und Dihydrogenphosphaten von Natrium, Kalium, Magnesium, Calcium, Aluminium, Zink, Eisen, Kobalt und Kupfer,
(b) 1 bis 40 Gew.-% mindestens einer Verbindung ausgewählt aus der Gruppe bestehend aus Oxiden, Hydroxiden und Oxidhydraten von Magnesium, Calcium, Eisen, Zink und Kupfer,
(c) 40 bis 95 Gew.-% mindestens eines partikelförmigen Füllstoffs ausgewählt aus der Gruppe bestehend aus Glas; Mono-, Oligo- und Polyphosphaten von Magnesium, Calcium, Barium und Aluminium; Calciumsulfat; Bariumsulfat; einfachen und komplexen Silikaten umfassend Natrium, Kalium, Calcium, Aluminium, Magnesium, Eisen und/oder Zirkonium; einfachen und komplexen Aluminaten umfassend Natrium, Kalium, Calcium, Magnesium und/oder Zirkonium; einfachen und komplexen Titanaten umfassend Natrium, Kalium, Calcium, Aluminium, Magnesium, Barium und/oder Zirkonium; einfachen und komplexen Zirkonaten umfassend Natrium, Kalium, Calcium, Aluminium und/oder Magnesium; Zirkoniumdioxid; Titandioxid; Aluminiumoxid; Siliziumdioxid; Siliziumcarbid; Aluminiumnitrid; Bornitrid und Siliziumnitrid, und
(d) 0 bis 25 Gew.-% mindestens eines von den Bestandteilen (a) bis (c) verschiedenen Bestandteils,
wobei sich die Gew.-Anteile der Bestandteile (a) bis (c) respektive (a) bis (d) zu 100 Gew.-% addieren,
wobei es sich bei den komplexen Silikaten, komplexen Aluminaten, komplexen Titanaten und komplexen Zirkonaten um Silikate, Aluminate, Titanate und Zirkonate mit mehr als einer Art von Kationen handelt,
wobei Bestandteil (a) bis zu 10 Gew.-% freies Wasser, welches nicht als Kristallwasser im mindestens einen Hydrogenphosphat gebunden ist, bezogen auf den gesamten Bestandteil (a) umfassen kann,
wobei Bestandteil (d) bis zu 10 Gew.-% Wasser, bezogen auf den gesamten Bestandteil (d) umfassen kann,
wobei die Zusammensetzung als Zweikomponentensystem vorliegt, und wobei die Bestandteile (a) und (b) separat voneinander vorliegen.

2. Zusammensetzung nach Anspruch 1, wobei es sich bei Bestandteil (a) um mindestens ein Hydrogenphosphat ausgewählt aus der Gruppe bestehend aus Mono- und Dihydrogenphosphaten von Magnesium, Kalium und Aluminium handelt.

3. Zusammensetzung nach Anspruch 1 oder 2, wobei es sich bei Bestandteil (b) um mindestens eine Verbindung ausgewählt aus der Gruppe bestehend aus Magnesiumoxid, Eisenoxid und Calciumoxid handelt.

4. Zusammensetzung nach einem der vorhergehenden Ansprüche, wobei es sich bei Bestandteil (c) um mindestens einen partikelförmigen Füllstoff ausgewählt aus der Gruppe bestehend aus Zirkoniumsilikat, Kieselsäure und Quarz handelt.

5. Zusammensetzung nach einem der vorhergehenden Ansprüche, wobei die Komponenten des Zweikomponentensystems in einer dem Mengenverhältnis der Bestandteile (a) bis (d) entsprechenden Bereitstellungsmenge vorliegen.

6. Im industriellen Maßstab im Rahmen einer industriellen Serienproduktion durchgeführtes Verfahren zur Herstellung einer hydraulisch gehärteten Umhüllung einer elektronischen Komponente, umfassend die Schritte:
(1) Bereitstellen einer zu umhüllenden elektronischen Komponente,
(2) Bereitstellen einer wässrigen Umhüllungsmasse in Form einer wässrigen hydraulisch härtbaren Zubereitung hergestellt durch Vermischen der Komponenten einer Zusammensetzung nach einem der Ansprüche 1 bis 5 miteinander und mit Wasser, wobei jede der beiden Komponenten des Zweikomponentensystems zunächst mit Wasser zu einem wässrigen Intermediat vermischt wird, bevor ein Weitervermischen erfolgt,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse,
wobei die zu umhüllende elektronische Komponente ein passives elektronisches Bauteil oder ein Halbleitermodul ist,
wobei Schritt (2) folgende Teilschritte umfasst:
(2a) Bereitstellen einer Zweikomponenten-Zusammensetzung nach einem der Ansprüche 1 bis 5 aus einer ersten Komponente A umfassend Bestandteil (a) und einer zweiten Komponente B umfassend Bestandteil (b),
(2b) separates Vermischen jeder der Komponenten A und B mit Wasser zu zwei separaten wässrigen Intermediaten A' und B', und
(2c) Vermischen der wässrigen Intermediate A' und B' mittels eines statischen Mischers zu einer wässrigen Umhüllungsmasse in Form der wässrigen hydraulisch härtbaren Zubereitung.

7. Verfahren nach Anspruch 6, wobei die beiden wässrigen Intermediate A' und B' um nicht mehr als 20 % voneinander abweichende Volumina und/oder jeweils eine Viskosität im Bereich von 0,5 bis 50 Pa s aufweisen, wobei es sich bei den Viskositätswerten um mittels Rotationsviskosimetrie mit Platte-Platte-Messprinzip bei einem Plattendurchmesser von 25 mm, einem Messspalt von 1 mm, einer Probentemperatur von 20°C und einer Scherrate von 36 min⁻¹ nach einer Messdauer von 2 Minuten bestimmte Viskositätswerte handelt.

## Claims

1. A composition consisting of the following constituents:
(a) 1 to 30 wt.% of at least one hydrogen phosphate selected from the group consisting of mono- and dihydrogen phosphates of sodium, potassium, magnesium, calcium, aluminum, zinc, iron, cobalt and copper,
(b) 1 to 40 wt.% of at least one compound selected from the group consisting of oxides, hydroxides and oxide hydrates of magnesium, calcium, iron, zinc and copper,
(c) 40 to 95 wt.% of at least one particulate filler selected from the group consisting of glass, mono-, oligo- and polyphosphates of magnesium, calcium, barium, and aluminum; calcium sulfate; barium sulfate; simple and complex silicates comprising sodium, potassium, calcium, aluminum, magnesium, iron and/or zirconium; simple and complex aluminates comprising sodium, potassium, calcium, magnesium, and/or zirconium; simple and complex titanates comprising sodium, potassium, calcium, aluminum, magnesium, barium and/or zirconium; simple and complex zirconates comprising sodium, potassium, calcium, aluminum, and/or magnesium; zirconium dioxide; titanium dioxide; aluminum oxide; silicon dioxide; silicon carbide; aluminum nitride; boron nitride and silicon nitride, and
(d) 0 to 25 wt.% of at least one constituent other than constituents (a) to (c),
wherein the weight proportions of constituents (a) to (c) or (a) to (d) add up to 100 wt.%,
wherein complex silicates, complex aluminates, complex titanates and complex zirconates are silicates, aluminates, titanates and zirconates with more than one type of cation,
wherein constituent (a) may comprise up to 10 wt.% of free water which is not bound as crystal water in the at least one hydrogen phosphate, based on the total constituent (a),
wherein constituent (d) may comprise up to 10 wt.% of water, based on the total constituent (d), wherein the composition is present as a two-component system, and wherein constituents (a) and (b) are present separately from one another.

2. The composition according to claim 1, wherein constituent (a) is at least one hydrogen phosphate selected from the group consisting of mono- and dihydrogen phosphates of magnesium, potassium and aluminum.

3. The composition according to claim 1 or 2, wherein constituent (b) is at least one compound selected from the group consisting of magnesium oxide, iron oxide and calcium oxide.

4. The composition according to any of the preceding claims, wherein constituent (c) is at least one particulate filler selected from the group consisting of zirconium silicate, silica and quartz.

5. The composition according to any of the preceding claims, wherein the components of the two-component system are present in a quantity corresponding to the quantitative ratio of constituents (a) to (d).

6. A method carried out on an industrial scale in the context of industrial series production for producing a hydraulically cured encapsulation of an electronic component, comprising the following steps:
(1) providing an electronic component to be encapsulated,
(2) providing an aqueous encapsulation compound in the form of an aqueous hydraulically curable preparation prepared by mixing the components of a composition according to any of claims 1 to 5 with one another and with water, wherein each of the two components of the two-component system is first mixed with water to form an aqueous intermediate before further mixing takes place,
(3) encapsulating the electronic component provided in step (1) with the aqueous encapsulation compound provided in step (2), and
(4) hydraulically curing the aqueous encapsulation compound encapsulating the electronic component after completion of step (3),
wherein the electronic component to be encapsulated is a passive electronic component or a semiconductor module,
wherein step (2) comprises the following substeps:
(2a) providing a two-component composition according to any of claims 1 to 5 consisting of a first component A comprising constituent (a) and a second component B comprising constituent (b),
(2b) separately mixing each of components A and B with water to form two separate aqueous intermediates A' and B', and
(2c) mixing the aqueous intermediates A' and B' by means of a static mixer to form an aqueous encapsulation compound in the form of the aqueous hydraulically curable preparation.

7. The method according to claim 6, wherein the two aqueous intermediates A' and B' have volumes which differ from one another by no more than 20% and/or each have a viscosity in the range of from 0.5 to 50 Pa.s, wherein the viscosity values are viscosity values determined by means of rotational viscometry using the plate-plate measuring principle with a plate diameter of 25 mm, a measuring gap of 1 mm, a sample temperature of 20°C and a shear rate of 36 min⁻¹ after a measurement period of 2 minutes.

## Revendications

1. Composition constituée des constituants suivants :
(a) 1 à 30 % en poids d'au moins un hydrogénophosphate choisi dans le groupe constitué de monohydrogénophosphates et dihydrogénophosphates de sodium, potassium, magnésium, calcium, aluminium, zinc, fer, cobalt et cuivre,
(b) 1 à 40 % en poids d'au moins un composé choisi dans le groupe constitué d'oxydes, hydroxydes et hydrates d'oxyde de magnésium, calcium, fer, zinc et cuivre,
(c) 40 à 95 % en poids d'au moins une matière de charge particulaire choisie dans le groupe constitué de verre ; monophosphates, oligophosphates et polyphosphates de magnésium, calcium, baryum et aluminium ; sulfate de calcium ; sulfate de baryum ; silicates simples et complexes comprenant du sodium, potassium, calcium, aluminium, magnésium, fer et/ou zirconium ; aluminates simples et complexes comprenant du sodium, potassium, calcium, magnésium et/ou zirconium ; titanates simples et complexes comprenant du sodium, potassium, calcium, aluminium, magnésium, baryum et/ou zirconium ; zirconates simples et complexes comprenant du sodium, potassium, calcium, aluminium et/ou magnésium ; dioxyde de zirconium ; dioxyde de titane ; oxyde d'aluminium ; dioxyde de silicium ; carbure de silicium ; nitrure d'aluminium ; nitrure de bore et nitrure de silicium, et
(d) 0 à 25 % en poids d'au moins un constituant différent des constituants (a) à (c), dans laquelle les proportions en poids des constituants (a) à (c), respectivement (a) à (d), s'additionnent à 100 % en poids,
dans laquelle les silicates complexes, aluminates complexes, titanates complexes et zirconates complexes sont des silicates, aluminates, titanates et zirconates ayant plus d'un type de cation,
dans laquelle le constituant (a) peut comprendre jusqu'à 10 % en poids d'eau libre qui n'est pas liée sous forme d'eau de cristallisation dans l'au moins un hydrogénophosphate, par rapport au constituant (a) total,
dans laquelle le constituant (d) peut comprendre jusqu'à 10 % en poids d'eau, par rapport au constituant (d) total,
dans laquelle la composition est présente sous forme de système à deux composants, et dans laquelle les constituants (a) et (b) sont présents séparément l'un de l'autre.

2. Composition selon la revendication 1, dans laquelle le constituant (a) est au moins un hydrogénophosphate choisi dans le groupe constitué de monohydrogénophosphates et dihydrogénophosphates de magnésium, potassium et aluminium.

3. Composition selon la revendication 1 ou 2, dans laquelle le constituant (b) est au moins un composé choisi dans le groupe constitué d'oxyde de magnésium, oxyde de fer et oxyde de calcium.

4. Composition selon l'une des revendications précédentes, dans laquelle le constituant (c) est au moins une matière de charge particulaire choisie dans le groupe constitué de silicate de zirconium, acide silicique et quartz.

5. Composition selon l'une des revendications précédentes, dans laquelle les composants du système à deux composants sont présents en une quantité de mise à disposition correspondant au rapport quantitatif des constituants (a) à (d).

6. Procédé mis en oeuvre à l'échelle industrielle dans le cadre d'une production industrielle en série pour la fabrication d'un enrobage durci de manière hydraulique d'un composant électronique, comprenant les étapes consistant à :
(1) mettre à disposition un composant électronique à enrober,
(2) mettre à disposition une matière d'enrobage aqueuse sous forme d'une préparation aqueuse durcissable de manière hydraulique fabriquée par mélange des composants d'une composition selon l'une des revendications 1 à 5 entre eux et avec de l'eau, dans lequel chacun des deux composants du système à deux composants est d'abord mélangé avec de l'eau pour former un intermédiaire aqueux avant de procéder à un mélange ultérieur,
(3) enrober le composant électronique mis à disposition à l'étape (1) avec la matière d'enrobage aqueuse mise à disposition à l'étape (2), et
(4) durcir de manière hydraulique la matière d'enrobage aqueuse enrobant le composant électronique après la fin de l'étape (3),
dans lequel le composant électronique à enrober est un composant électronique passif ou un module à semi-conducteurs,
dans lequel l'étape (2) comprend les étapes partielles suivantes :
(2a) mettre à disposition une composition à deux composants selon l'une des revendications 1 à 5 à partir d'un premier composant A comprenant le constituant (a) et d'un second composant B comprenant le constituant (b),
(2b) mélanger séparément chacun des composants A et B avec de l'eau pour former deux intermédiaires aqueux distincts A' et B' ; et
(2c) mélanger les intermédiaires aqueux A' et B' au moyen d'un mélangeur statique pour former une matière d'enrobage aqueuse sous forme de la préparation aqueuse durcissable de manière hydraulique.

7. Procédé selon la revendication 6, dans lequel les deux intermédiaires aqueux A' et B' présentent des volumes qui ne différent pas de plus de 20 % l'un de l'autre et/ou présentent respectivement une viscosité dans la plage allant de 0,5 à 50 Pa·s, dans lequel les valeurs de viscosité sont des valeurs de viscosité déterminées par un viscosimètre rotatif avec le principe de mesure plaque à plaque avec un diamètre de plaque de 25 mm, une fente de mesure de 1 mm, une température d'échantillon de 20 °C et un taux de cisaillement de 36 min⁻¹ après une durée de mesure de 2 minutes.
